# EUROPÄISCHE PATENTANMELDUNG

(11) **EP 1 826 821 A2**
(43) Veröffentlichungstag der Anmeldung: **29.08.2007**
(21) Anmeldenummer: 07003349.3
(22) Anmeldetag: 16.02.2007
(51) Int. Cl.: H01L 27/32, H01L 51/52

(54) **Elektrolumineszierende Vorrichtung und Verfahren zu dessen Herstellung**

(30) Priorität: 28.02.2006 DE 102006009217
(71) Anmelder: Osram Opto Semiconductors GmbH, 93049 Regensburg (DE)
(72) Erfinder: Abdul Manaf, Shahrol Izzanni, 10150 Penang (MY); Grespan, Silvio, 10250 Penang (MY)
(74) Vertreter: Epping - Hermann - Fischer

(57) **Zusammenfassung**

In einer Ausführungsform beschreibt die Erfindung eine e-lektrolumineszierende Vorrichtung 1 mit einem funktionellen Bereich 5, der Licht mit einer ersten spektralen Verteilung 7 emittiert und mit einer Filterschicht 10, die im Strählengang 6 des funktionellen Bereichs 5 angeordnet ist und spektrale Teilbereiche des Lichts der ersten spektralen Verteilung absorbiert, so dass Licht mit einer zweiten spektralen Verteilung von der Vorrichtung 1 emittiert wird.

## Beschreibung

Die Patentanmeldung betrifft eine elektrolumineszierende Vorrichtung, bei der eine einfache Einstellung des von der Vorrichtung emittierten und vom Betrachter wahrgenommenen Lichts möglich ist.

Dies wird durch eine Vorrichtung nach Anspruch 1 gelöst. Weitere Ausgestaltungen der Vorrichtung sowie ein Verfahren zu dessen Herstellung sind Gegenstand weiterer Ansprüche.

Eine Ausführungsform der Erfindung gibt eine elektrolumineszierende Vorrichtung an, die einen funktionellen Bereich aufweist, der Licht mit einer ersten spektralen Verteilung emittiert und zusätzlich eine Filterschicht aufweist, die im Strahlengang des funktionellen Bereichs angeordnet ist und spektrale Teilbereiche des Lichts der ersten spektralen Verteilung absorbiert, sodass Licht mit einer zweiten spektralen Verteilung von der Vorrichtung emittiert wird.

Dieses Licht kann dann von einem Betrachter außerhalb der Vorrichtung als eigentliches, im Bereich der Filterschicht von der Vorrichtung emittiertes Licht wahrgenommen werden.

Die Filterschicht kann dabei Transmissionseigenschaften aufweisen, die es erlauben, Teile des Lichts der ersten spektralen Verteilung zu absorbieren beziehungsweise zu reflektieren, so dass das Licht mit der resultierenden zweiten spektralen Verteilung eine entsprechend reduzierte spektrale Verteilung aufweist (siehe beispielsweise die Figuren 6A bis 6C). Die Filterschicht kann beispielsweise in Form einer Folie vorliegen, sodass diese besonders einfach beispielsweise mittels Laminierens im Strahlengang des funktionellen Bereichs angeordnet werden kann. Die Filterschicht kann aber auch mittels von z. B. Druckverfahren auf verschiedenen Bereichen der Vorrichtung erzeugt werden.

Der funktionelle Bereich weist dabei vorteilhafterweise eine erste Elektrodenschicht, eine auf der ersten Elektrodenschicht angeordnete organische, funktionelle Schicht und eine zweite Elektrodenschicht auf der zumindest einen organischen funktionellen Schicht auf. Die organischen funktionellen Schichten können die weiter unten genannten organischen elektrolumineszierenden Materialien sein. Wird eine Spannung an die erste und zweite Elektrodenschicht angelegt, so werden Elektronen beziehungsweise "Löcher" in die zumindest eine organische funktionelle Schicht injiziert, wobei es bei einer Rekombination der Elektronen und "Löcher" zu einer Emission von Licht kommt (Elektrolumineszenz).

Vorteilhafterweise emittiert der funktionelle Bereich Licht einer Farbe. Dies lässt sich beispielsweise dadurch bewerkstelligen, dass nur eine einzige Licht emittierende funktionelle Schicht innerhalb des funktionellen Bereichs vorliegt, die nur aus einem einzigen Licht emittierenden Material besteht. Dieses Licht emittierende Material kann beispielsweise eine organische funktionelle Schicht, zum Beispiel auf der Basis von Polymeren wie Poly(p-phenylen-vinylen) (PPV) oder auf der Basis von so genannten niedermolekularen kleinen Molekülen ("small molecules") wie z. B. Tris(8-hydroxyquinolinato)-aluminum (Alq) sein. Die polymeren organischen Verbindungen lassen sich beispielsweise mittels naßchemischer Methoden, zum Beispiel Tintenstrahldruck, Spincoating oder Rakeln auf einem beliebigen Substrat aufbringen. Abgesehen davon können die so genannten "small molecules" auch mittels Gasphasenabscheidung auf jedes beliebige Substrat aufgebracht werden. Diese Vorrichtungen werden auch als organische Leuchtdioden (OLEDs) bezeichnet.

Weiterhin vorteilhaft ist es, wenn die erste Elektrodenschicht in parallel zueinander verlaufende erste Elektrodenstreifen strukturiert ist und die zweite Elektrodenschicht in parallel zueinander verlaufende zweite Elektrodenstreifen strukturiert ist, wobei die ersten und zweiten Elektrodenstreifen quer, vorteilhafterweise senkrecht zueinander verlaufen.

Bei einer derartigen Anordnung von ersten und zweiten Elektrodenstreifen lässt sich besonders einfach eine Passiv-Matrixanordnung realisieren, wobei an den Kreuzungspunkten der ersten und zweiten Elektrodenstreifen aktive leuchtende Bereiche, beispielsweise Bildpunkte gebildet werden, die mittels Anlegens einer Spannung an die ersten und zweiten Elektrodenstreifen selektiv angesteuert werden können. Eine derartige Passiv-Matrixanordnung ist besonders vorteilhaft für ein elektrolumineszierendes Display, beispielsweise ein organisches elektrolumineszierendes Display, das zum Darstellen von Informationen und zum Beispiel grafischen Elementen verwendet werden kann. Es ist aber auch möglich eine Aktiv-Matrixanordnung bei elektrolumineszierenden Vorrichtungen nach einigen Ausführungsformen der Erfindung zu realisieren, wobei dann auch diese Aktiv-Matrix-Anordnungen Bildpunkte umfassen.

Die Bildpunkte sowohl der Passiv- wie auch der Aktivmatrix-Anordungen sind vorteilhaft separat ansteuerbar (z. B. die oben genannten Kreuzungspunkte von senkrecht zueinander verlaufenden Elektrodenstreifen). Die Bildpunkte können weiterhin voneinander getrennte aktive elektrolumineszierende Bereiche umfassen oder auch Bestandteile einer einzigen zusammenhängenden elektrolumineszierenden Schicht sein.

Besonders vorteilhaft kann der funktionelle Bereich Weißlicht emittieren. Dazu können z. B. Mischungen verschiedener e-lektrolumineszierender Materialien verwendet werden, wobei dann aufgrund von Farbmischung der verschiedenen von den Materialien emittierten Farben Weiß resultiert oder es kann auch nur ein einziges Material, das von sich aus Weißlicht emittiert verwendet werden. Z. B. kann dass kommerziell von MOM (Merck-OLED Materials GmbH) erhältliche Material C-EXP-W001 verwendet werden. Ein Weißlicht emittierender funktioneller Bereich, beziehungsweise eine Weißlicht emittierende organische funktionelle Schicht innerhalb einer organischen elektrolumineszierenden Vorrichtung hat den Vorteil, dass mittels entsprechender Anordnung der Filterschicht und Ausgestaltung dieser Filterschicht in verschiedene Teilbereiche, die jeweils unterschiedliche spektrale Bereiche des Lichts absorbieren, besonders einfach eine elektrolumineszierende Vorrichtung erhalten werden kann, die verschiedenste Farben emittiert und somit eine vielfarbige bzw. vollfarbige Vorrichtung darstellt. Eine derartige Vorrichtung lässt sich dabei besonders einfach durch Erzeugen eines einzigen Licht emittierenden, zum Beispiel organischen Schichtbereichs auf der kompletten Oberfläche eines Substrats erreichen, wobei dann durch Variation der Filterschicht, beispielsweise ihre Aufteilung in verschiedene, unterschiedliche spektrale Teilbereiche des Lichts absorbierende Teilstrukturen besonders einfach eine Vorrichtung erhalten werden, die beliebige Farben emittiert und je nach Ausgestaltung der Filterschicht auch vollfarbig sein kann. Somit können bei elektrolumineszierenden Vorrichtungen der Erfindung bei gleichen elektrolumineszierenden Materialen allein durch Variation der Filterschicht Vorrichtungen erhalten werden, die vom Betrachter wahrgenommenes Licht unterschiedlicher Wellenlänge emittieren.

Bei einer weiteren Ausführungsform der Erfindung umfasst die Filterschicht Teilbereiche, die jeweils unterschiedliche Licht-absorbierende oder -reflektierende Filtermaterialien aufweisen. Dabei kann vorteilhafterweise ein Teilbereich der Filterschicht nicht nur einem Bildpunkt, sondern zumindest zwei, weiter bevorzugt mehreren Bildpunkten zugeordnet sein.

Die Filterschicht kann günstigerweise organische Farbstoffe umfassen, die sich besonders leicht verarbeiten lassen uns z. B. bereits in der LCD (Liquid Crystal Display)-Industrie verwendet werden.

In einer weiteren Ausführungsform der Erfindung umfasst die Filterschicht eine Folienanordnung enthaltend eine adhäsive. Schicht, eine Kunststoffschicht auf der adhäsiven Schicht und eine Farbfilterschicht auf der Kunststoffschicht.

Eine derartige Folienanordnung kann besonders einfach, beispielsweise über die adhäsive Schicht fest mit der elektrolumineszierenden Vorrichtung verbunden werden. Die Kunststoffschicht dient dabei als eine Art Trägerschicht zwischen der adhäsiven Schicht und der Farbfilterschicht und umfasst bevorzugt Kunststoffe mit einer hohen Transmission, beispielsweise Polyester, Polycarbonat oder Polyethylen. Für die adhäsive Schicht können verschiedenste transparente Materialien, z. B. Epoxy oder ähnliches verwendet werden.

In anderen Ausführungsformen der Erfindung kann die Folienanordnung auch so aufgebaut sein, dass auf der Kunststoffschicht die Farbfilterschicht angeordnet ist, wobei auf dieser Farbfilterschicht dann die adhäsive Schicht sich befindet. Auch bei dieser Ausführungsform wird die Folienanordnung über die adhäsive Schicht mit der elektrolumineszierenden Vorrichtung verbunden.

Die Kunststoffschicht kann dabei auch doppelbrechend sein.

Bei einer anderen Ausführungsform der Erfindung ist eine Verkapselung über dem funktionellen Bereich vorhanden und der funktionelle Bereich ist auf einem Substrat angeordnet. In diesem Fall kann dann die Filterschicht auf der dem funktionellen Bereich abgewandten Fläche des Substrats und/oder der Verkapselung angeordnet sein.

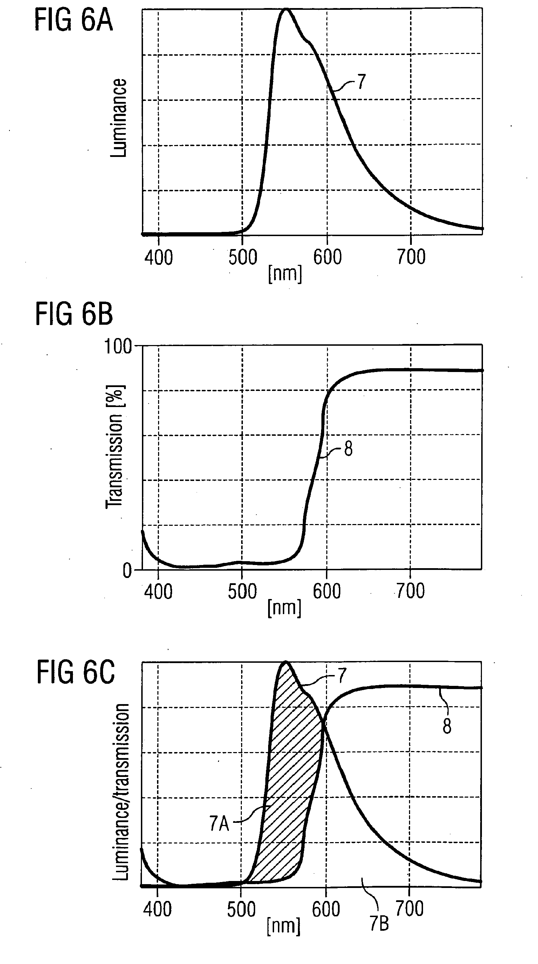

Bei einer derartigen Ausführungsform kann die Filterschicht besonders einfach auf den äußeren Flächen des Substrats beziehungsweise der Verkapselung angeordnet werden. In diesem Fall kann allein durch Variation der Filterschicht bei Beibehaltung ein und desselben funktionellen Bereichs eine Variation des vom Betrachter wahrgenommenen von der elektrolumineszierenden Vorrichtung abgestrahlten Lichts erreicht werden. Durch verschiedene geometrische Ausgestaltungen von unterschiedlich absorbierenden Teilbereichen der Filterschicht, wie beispielsweise in Figur 5 gezeigt, lassen sich somit viele verschiedene elektrolumineszierende Vorrichtungen allein durch Variation der Filterschicht realisieren. Im Falle eines Weißlicht emittierenden funktionellen Bereichs können durch unterschiedliche Anordnung der Filterschicht mit unterschiedlich absorbierenden Teilbereichen verschiedene geometrische Anordnungen und damit unterschiedliche Abstrahlungscharakteristika der elektrolumineszierenden Vorrichtung in Abhängigkeit von der Filterschicht besonders einfach realisiert werden.

Weiterhin ist es vorteilhaft, wenn die Filterschicht eine mittels eines Tintendruckverfahrens aufzubringende Licht absorbierende Tinte umfasst. Das Tintendruckverfahren ist eine besonders einfache Druckmethode, bei der auch gleichzeitig strukturierte Filterschichten besonders leicht zum Beispiel auf das Substrat oder die Verkapselung aufgebracht werden können.

Weiterhin kann im Strahlengang der Vorrichtung in weiteren Ausführungsformen der Erfindung zusätzlich ein Zirkularpolarisator angeordnet sein. Der Zirkularpolarisator kann bevorzugt schichtförmig ausgeformt sein und z. B. als Folie vorliegen.

Eine derartiger Zirkularpolarisator verhindert besonders gut eine Rückreflexion des von außen in die Vorrichtung eintretenden Lichts und erhöht damit auch den Kontrast der Vorrichtung bei heller Umgebung.

Besonders vorteilhaft ist die der Zirkularpolarisator dann, wenn eine Elektrodenschicht Licht reflektierend ist und beispielsweise spiegelnd ausgebildet ist. In diesem Fall kann beispielsweise die elektrolumineszierende Vorrichtung im ausgeschalteten Zustand als Spiegel dienen, während sie im eingeschalteten Zustand zur Beleuchtung dient beziehungsweise grafische Elemente oder Informationen anzeigt.

In dem Fall, dass eine Variante einer erfindungsgemäßen elektrolumineszierenden Vorrichtung sowohl eine Filterschicht als auch einen Zirkularpolarisator aufweist, sind besonders vorteilhaft verschiedene Anordnungsmöglichkeiten des Zirkularpolarisators relativ zur Filterschicht möglich:

In dem Fall, dass die Filterschicht eine der oben genannten Folienanordnungen umfasst und gleichzeitig die in der Folienanordnung vorhandene Kunststoffschicht ein im hohen Maße doppelbrechendes Material, beispielsweise Polycarbonat oder Polyester umfasst, ist besonders vorteilhaft die Folienanordnung der Filterschicht im Strahlengang der Vorrichtung dem Zirkularpolarisator nachgeordnet. Dies bedeutet, dass der Zirkularpolarisator im Strahlengang näher am funktionellen Bereich angeordnet ist als die Folienanordnung der Filterschicht. Weiter bevorzugt ist die Filterschicht auf dem Zirkularpolarisator angeordnet, der sich wiederum auf dem Substrat und/oder der Verkapselung der elektrolumineszierenden Vorrichtung befindet. Dadurch kann besonders einfach ein hoher Kontrast und ein dunkler Hintergrund gewährleistet werden.

Weiterhin ist es möglich, dass die Kunststoffschicht der Folienanordnung der Filterschicht ein Material enthält, das nicht doppelbrechend ist beziehungsweise nur geringe doppelbrechende Eigenschaften aufweist, so dass die Funktion des Zirkularpolarisators nicht oder nur geringfügig gestört wird. In diesem Fall kann die Filterschicht dem Zirkularpolarisator im Strahlengang der Vorrichtung vorgeschaltet sein. Dies lässt sich beispielsweise dadurch bewerkstelligen, dass der Zirkularpolarisator auf der Filterschicht angeordnet wird, wobei die Filterschicht näher am funktionellen, Licht emittierenden Bereich positioniert ist, als der Zirkularpolarisator. Eine derartige Anordnung ist besonders dazu geeignet, die Lichtstreuung der Filterschicht beziehungsweise der einzelnen Farbfilterbereiche der Filterschicht unter dem Zirkularpolarisator zu verbergen, sodass die verschiedenen Farben der Filterschicht im ausgeschalteten Zustand der Vorrichtung nicht oder nur im eingeschränkten Maße sichtbar sind.

Weiterhin ist es möglich, dass die Filterschicht keine der oben genannten Folienanordnungen umfasst, sondern beispielsweise mittels eines Druckverfahrens, zum Beispiel Tintenstrahldruck, oder Tampondruck erzeugt wird. In diesem Fall lässt sich beispielsweise mittels der oben genannten Druckverfahren die Filterschicht besonders einfach auf einer vorhandenen Verkapselung und/oder einem vorhandenen Substrat auf dem der funktionelle Bereich angeordnet ist, erzeugen. Auch in diesem Fall kann die Filterschicht dem Zirkularpolarisator im Strahlengang der Vorrichtung je nach Anwendung entweder vor- oder nachgeschaltet sein.

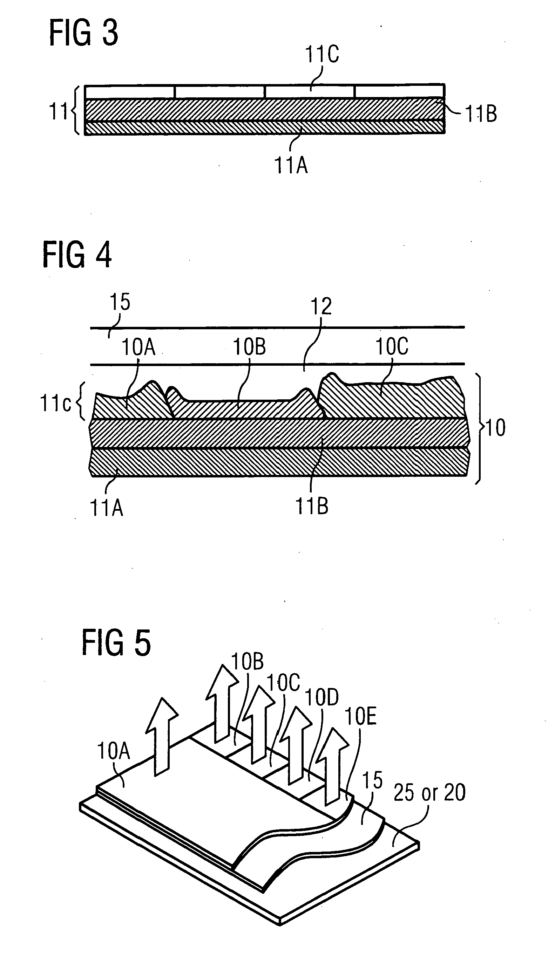

In den Fällen, in denen der Zirkularpolarisator auf der Filterschicht angeordnet ist, ist es besonders vorteilhaft, wenn eine Planarisierungsschicht zwischen dem Zirkularpolarisator und der Filterschicht vorhanden ist (siehe beispielsweise Figur 4) .

Eine derartige Planarisierungsschicht kann dabei besonders einfach die Unebenheiten der Filterschicht, zum Beispiel die Unebenheiten der einzelnen Teilbereiche der Filterschicht mit zum Beispiel unterschiedlichen Filtermaterialien besonders einfach ausgleichen, sodass auf der Planarisierungsschicht dann besonders gut, beispielsweise mittels Klebens oder Laminierens, der Zirkularpolarisator angeordnet werden kann. Als Materialien für die Planarisierungsschicht kommen z. B. Epoxy oder ähnliches transparentes Material in Frage.

Bei einer weiteren Ausführungsform der Erfindung können zumindest Teilbereiche der Filterschicht zu grafischen Elementen strukturiert sein. Diese grafischen Elemente können dann während des Betriebs der Vorrichtung angezeigt werden. Durch Variation dieser grafischen Ausgestaltung lassen sich somit bei gleichen funktionellen Bereichen elektrolumineszierende Vorrichtungen realisieren, die auf Grund der Variation der Filterschicht unterschiedliche grafische Elemente anzeigen.

Gegenstand der Erfindung sind weiterhin verschiedene Ausführungsformen eines Verfahrens zur Herstellung der elektrolumineszierenden Vorrichtung. In einer Ausführungsform umfasst das Verfahren die Verfahrensschritte:
A) Der funktionelle Bereich wird bereitgestellt,
B) die Filterschicht wird im Strahlengang des funktionellen Bereichs erzeugt.

Der funktionelle Bereich wird besonders vorteilhaft im Verfahrensschritt A) auf einem Substrat erzeugt und dann eine Verkapselung über dem funktionellen Bereich auf dem Substrat angebracht. Dabei kann dann im Verfahrensschritt B) die Filterschicht auf der, dem funktionellen Bereich abgewandten Fläche des Substrats und/oder der Verkapselung erzeugt werden.

Weiterhin kann bei einer Ausführungsform eines erfindungsgemäßen Verfahrens in einem weiteren Verfahrensschritt C) ein Zirkularpolarisator auf der, dem funktionellen Bereich abgewandten Fläche des Substrats und/oder der Verkapselung erzeugt werden. Wie bereits oben genannt, kann je nach Bedarf der Zirkularpolarisator im Strahlengang der Filterschicht vorgeschaltet oder nachgeordnet sein.

Die Filterschicht kann dabei in Form der bereits oben erwähnten Folienanordnung beispielsweise auf dem Substrat oder der Verkapselung erzeugt werden, wobei dies beispielsweise mittels Laminierens oder Verklebens erfolgen kann. Weiterhin kann die Filterschicht auch z. B. mittels verschiedener Druckverfahren auf dem Substrat und/oder der Verkapselung erzeugt werden.

Die elektrolumineszierenden Vorrichtungen gemäß der verschiedenen Ausführungsformen der Erfindung können beispielsweise zu Beleuchtungszwecken verwendet werden. Möglich ist es aber auch, die Vorrichtungen als Displays zur Darstellung von grafischen Elementen und/oder Informationen, beispielsweise Zahlen oder Buchstaben zu verwenden.

Beispielsweise ist es möglich, die oben erwähnte Passivmatrixanordnung oder die Aktivmatrixanordnungen mit quer beziehungsweise senkrecht zueinander verlaufenden ersten und zweiten Elektrodenstreifen auch in einer Beleuchtungsvorrichtung zu verwenden. In diesem Fall dienen die Kreuzungspunkte der jeweiligen ersten und zweiten Elektrodenstreifen als aktive Beleuchtungspunkte, die jeweils separat oder zusammen mit allen anderen Beleuchtungspunkten zur Beleuchtung von zum Beispiel Räumen eingesetzt werden können.

Im Folgenden wird die Erfindung anhand von Ausführungsbeispielen und Figuren noch näher erläutert. Die Figuren sind dabei schematisch und nicht maßstabsgetreu.
- Figur 1: zeigt eine Ausführungsform einer erfindungsgemäßen elektrolumineszierenden Vorrichtung.
- Figur 2: zeigt eine weitere Ausführungsform einer erfindungsgemäßen elektrolumineszierenden Vorrichtung.
- Figur 3: zeigt eine Folienanordnung als Beispiel einer Filterschicht.
- Figur 4: zeigt eine Anordnung eines Zirkularpolarisators auf einer Filterschicht, wobei eine Planarisierungsschicht vorhanden ist.
- Figur 5: zeigt eine weitere Ausgestaltung einer Filterschicht mit unterschiedlichen Licht absorbierenden Teilbereichen.
- Die Figuren 6A bis 6C: verdeutlichen das Funktionsprinzip der Filterschicht.
- Figur 7: zeigt eine Tampondruckmaschine zur Erzeugung einer Filterschicht auf einer elektrolumineszierenden Vorrichtung.

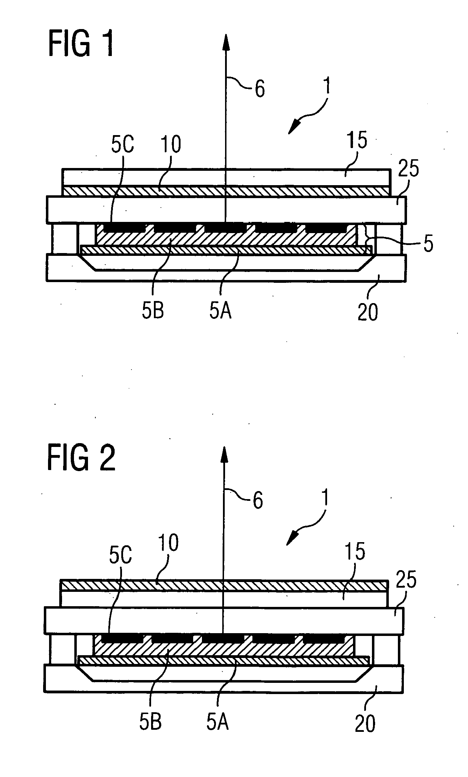

Figur 1 zeigt eine organische elektrolumineszierende Vorrichtung 1, bei der der funktionelle Bereich 5 erste Elektrodenstreifen 5A und dazu senkrecht verlaufende zweite Elektrodenstreifen 5C aufweist, wobei dazwischen zumindest eine funktionelle organische Schicht 5B angeordnet ist, die in diesem Fall aus drei Schichten besteht. Bei diesen drei Schichten kann es sich beispielsweise um Löcher transportierende Schichten, Elektronen transportierende Schichten und einer dazwischen angeordneten Licht emittierenden Schicht handeln. Möglich sind aber z. B. auch beliebige andere Schichtanordnungen wie eine PEDOT (Polyethylendioxythiophen)-PPV-Zweischichtanordnung. Der funktionelle Bereich 5 ist auf einem Substrat 20 angeordnet, das mittels einer Verkapselung 25 gegenüber Umgebungseinflüssen, beispielsweise oxidierenden Permeantien und Wasser verkapselt ist. Die ersten Elektrodenstreifen 5A können dabei Licht reflektierend beziehungsweise spiegelnd ausgeführt sein, sodass der hauptsächliche Strahlengang 6 der elektrolumineszierenden Vorrichtung 1 durch die Verkapselung 25 verläuft. Auf der äußeren Oberfläche der Verkapselung 25 sind eine Filterschicht 10 und ein Zirkularpolarisator 15 angeordnet. In diesem Fall ist die Filterschicht 10 im Strahlengang 6 der elektrolumineszierenden Vorrichtung 1 dem Zirkularpolarisator 15 vorgeschaltet, wobei der Zirkularpolarisator auf der Filterschicht angeordnet ist. Möglich sind aber auch erfindungsgemäße elektrolumineszierende Vorrichtungen bei denen das erzeugte Licht durch das transparente Substrat 20 ausgekoppelt wird und dann dementsprechend der Zirkularpolarisator und die Filterschicht auf der äußeren Oberfläche des Substrats angeordnet sind.

Figur 2 zeigt die gleiche organische elektrolumineszierende Vorrichtung 1 wie Figur 1 dargestellt, wobei im Gegensatz zu Figur 1 die Reihenfolge der Filterschicht 10 und des Zirkularpolarisators 15 vertauscht wurden, sodass in diesem Fall die Filterschicht 10 im Strahlengang 6 der elektrolumineszierenden Vorrichtung 1 dem Zirkularpolarisator 15 nachgeschaltet ist.

Figur 3 zeigt im Detail eine vereinfachte Darstellung einer Folienanordnung 11 einer Filterschicht 10. Dabei ist zu erkennen, dass eine adhäsive Schicht 11A vorhanden ist, auf der eine Kunststoffschicht 11B angeordnet ist. Auf der Kunststoffschicht 11B befindet sich eine Farbfilterschicht 11C, die entweder Materialien der gleichen chemischen Zusammensetzung aufweist oder unterschiedliche hier gezeigte Teilbereiche aufweist, die unterschiedliche jeweils Licht unterschiedlicher Wellenlänge absorbierende Teilfilterbereiche aufweist. Wie bereits oben erwähnt, kann die adhäsive Schicht 11A besonders einfach zur Befestigung der Folienanordnung 11 auf einer erfindungsgemäßen elektrolumineszierenden Vorrichtung dienen.

Figur 4 zeigt eine Anordnung aus einer Filterschicht 10 einer darauf angeordneten Planarisierungsschicht 12 und eines Zirkularpolarisators 15 auf der Planarisierungsschicht 12. Dabei handelt es sich um einen Ausschnitt aus der kompletten Schichtanordnung. Eine Planarisierungsschicht 12 ist beispielsweise dann besonders gut geeignet, die hier dargestellten Unebenheiten der Teilbereiche 10A, 10B und 10C der Farbfilterschicht 11C zu planarisieren, wenn der Zirkularpolarisator 15 auf der Filterschicht 10 angeordnet wird, wie dies beispielsweise in Figur 1 gezeigt ist. Die Filterschicht 10 umfasst dabei wieder zusätzlich eine adhäsive Schicht 11A und eine Kunststoffschicht 11B.

Figur 5 zeigt eine besondere Ausgestaltung der Filterschicht 10, bei der hier zumindest fünf unterschiedliche Teilbereiche 10A bis 10E vorhanden sind, die unterschiedliche Licht absorbierende Filtermaterialien aufweisen und damit zur Emission von Licht unterschiedlicher Wellenlänge führen. Dabei ist die Filterschicht 10 auf dem Zirkularpolarisator 15 angeordnet, die sich wiederum auf dem Substrat 20 oder der Verkapselung 25 befindet.

Figur 6A zeigt in einer Grafik, bei der die Luminanz gegen die Wellenlänge aufgetragen ist, die erste spektrale Verteilung 7 des Lichts, das von einem funktionellen Bereich 5 einer elektrolumineszierenden Vorrichtung 1 der Erfindung emittiert wird. In diesem Fall wird dabei ein auf Grund der spektralen Verteilung dem Betrachter gelb erscheinendes Licht emittiert.

Figur 6B zeigt den Verlauf einer Transmission 8 einer Filterschicht 10 beziehungsweise eines Teilbereichs 10A, 10B oder 10C einer Filterschicht 10 in Abhängigkeit von der Wellenlänge. Dabei ist zu erkennen, dass der Filter im Bereich zwischen etwa 400 nm und 580 nm eine sehr geringe Transmission aufweist und somit das meiste Licht in diesem Wellenlängenbereich entweder absorbiert oder reflektiert. Bei einem Wellenlängenbereich von etwa 600 nm bis über 800 nm wird eine sehr hohe Transmission erreicht, so dass der größte Teil des Lichts die Filterschicht passieren kann.

Figur 6C zeigt in einer vereinfachten grafischen Darstellung wie die Filterschicht 10 der Figur 6B mit dem von funktionellen Bereich 5 emittierten Licht gemäß Fig. 6A wechselwirkt. Dabei ist zu erkennen, dass auf Grund der Transmissionseigenschaften 8 der Filterschicht die erste spektrale Verteilung 7 des vom funktionellen Bereich emittierten Lichts auf Grund der Absorption beziehungsweise Reflexion der absorbierten Teilbereiche 7A (schraffierte Fläche) in der Filterschicht ein Licht mit der zweiten spektralen Verteilung 7B ergibt. Auf Grund dieser Anordnung wird beispielsweise bei einem gelb emittierenden Licht und dem hier vorliegenden rot-orangenen Filter ein tief oranges Licht aus der elektrolumineszierenden Vorrichtung ausgekoppelt und vom Betrachter wahrgenommen. Es ist auch möglich, beliebige andere Kombinationen von, von dem funktionellen Bereich emittierten Licht mit unterschiedlich absorbierenden Filterschichten zu kombinieren, sodass Licht jeder beliebigen Farbe erhalten werden kann. Um das Spektrum des von einem Betrachter wahrgenommenen von der elektrolumineszierenden Vorrichtung abgestrahlten Lichts zu erhalten wird das Spektrum des von dem funktionellen Bereich emittierten Lichts mit der Transmission der Filterschicht multipliziert.

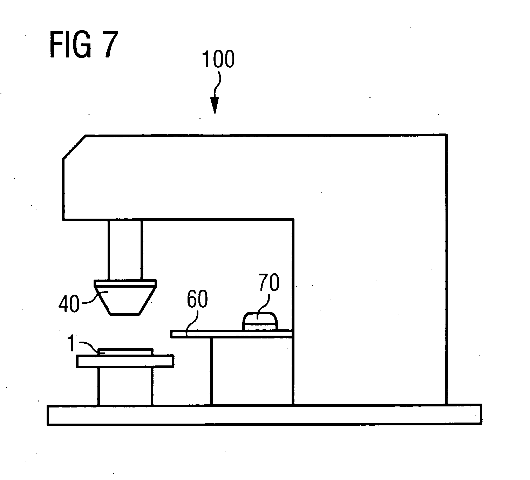

Figur 7 zeigt eine schematische Darstellung einer Tampondruckmaschine 100, die zum Erzeugen einer Farbschicht als der Filterschicht auf einer elektrolumineszierenden Vorrichtung 1 geeignet ist. Mit 40 ist dabei ein Tampon und mit 60 ein Druckstock bezeichnet. Auf Grund des Druckverfahrens sowie durch Variation der Dicke der aufgebrachten Tintenabsorptionsschicht als der Filterschicht und der Konzentration der absorbierenden Farbstoffe kann besonders vorteilhaft eine Feinabstimmung der letztendlich vom Betrachter wahrgenommenen emittierten Lichtstrahlung von erfindungsgemäßen elektrolumineszierenden Vorrichtungen erreicht werden. Eine Tampondruckmaschine kann besonders im Zusammenspiel mit einem optischen Positionierungs- und Ausrichtungssystem eine besonders genaue Erzeugung der Filterschicht gewährleisten. Die Tampondruckmaschine umfasst dabei einen einzelnen oder mehrere Druckstöcke, in denen das Design beziehungsweise die Struktur der Filterschicht eingeätzt ist. Weiterhin sind einzelne oder mehrere Tampons für den Transfer der Licht absorbierenden Tinte auf das Substrat beziehungsweise die Verkapselung der elektrolumineszierenden Vorrichtung vorhanden. Für Standardverfahren ist ein 64 Wire/cm-Druckstock ausreichend, um eine einheitliche Aufbringung der Tinte auf der elektrolumineszierenden Vorrichtung zu gewährleisten. Für spezielle Designs mit einem kleinen zu bedruckenden Bereich kann ein Druckstock mit mehreren Wires verwendet werden.

Die Dicke der Tintenschicht hat einen Einfluss auf die finale Farbsättigung und die Lichttransmission der Filterschicht.

Eine geringere Dicke der Tinte führt zu einer weniger gesättigten Farbe des letztendlich vom Betrachter wahrgenommenen emittierten Lichts und einer hohen Lichttransmission, während eine größere Dicke der Tintenschicht beim Betrachter einen gesättigten Farbeindruck hinterlässt, bei gleichzeitig niedrigerer Lichttransmission.

Die Dicke der Schicht der Tinte kann in erster Linie durch die Ätztiefe des Druckstocks und der Art des Tampons beeinflusst werden. Eine Ätztiefe von 20 µm führt bei einem Druckstock zu einer einheitlichen Bedeckung, die gleichzeitig einen guten Kompromiss zwischen einer guten Transmission und Sättigung der vom Betrachter wahrgenommenen Farben darstellt. Je nach der beabsichtigten Anwendung können zwei verschiedene Tintenmaterialien verwendet werden. Bei Anwendungen in einem Standardtemperaturbereich und bei niedrigem mechanischem Stress können UV-härtbare Tinten verwendet werden. Bei einem breiteren einzusetzenden Temperaturbereich mit hohem mechanischem Stress können Zweikomponenten-Tinten verwendet werden, da sie eine höhere Adhäsion an das Glas des Substrats und/oder der Verkapselung aufweisen.

Die hier dargestellte Erfindung beschränkt sich nicht auf die hier gezeigten Ausführungsbeispiele. Weitere Ausführungsbeispiele sind beispielsweise auf Grund unterschiedlicher geometrischer Ausformungen der Filterschicht möglich.

## Patentansprüche

1. Elektrolumineszierende Vorrichtung (1)
- mit einem funktionellen Bereich (5), der Licht mit einer ersten spektralen Verteilung (7) emittiert und
- mit einer Filterschicht (10), die im Strahlengang (6) des funktionellen Bereichs (5) angeordnet ist und spektrale Teilbereiche des Lichts der ersten spektralen Verteilung absorbiert, so dass Licht mit einer zweiten spektralen Verteilung von der Vorrichtung (1) emittiert wird.

2. Vorrichtung nach dem vorhergehenden Anspruch,
- bei der der funktionelle Bereich (5) Weißlicht emittieren kann.

3. Vorrichtung (1) nach einem der vorhergehenden Ansprüche ausgebildet als organische, elektrolumineszierende Vorrichtung wobei der funktionelle Bereich (5)
- eine erste Elektrodenschicht (5A),
- zumindest eine auf der ersten Elektrodenschicht angeordnete organische, funktionelle Schicht (5B), und
- eine zweite Elektrodenschicht (5C) auf der zumindest einen organischen funktionellen Schicht (5B) umfasst.

4. Vorrichtung (1) nach dem vorhergehenden Anspruch,
- bei der die erste Elektrodenschicht (5A) parallel zueinander verlaufende erste Elektrodenstreifen und die zweite Elektrodenschicht (5C) parallel zueinander verlaufende zweite Elektrodenstreifen umfassen,
- wobei die ersten und zweiten Elektrodenstreifen quer zueinander verlaufen.

5. Vorrichtung (1) nach einer der vorhergehenden Ansprüche,
- bei der die Filterschicht (10) verschiedene Teilbereiche(10A, 10B, 10C, 10D, 10E) umfasst, die jeweils unterschiedliche spektrale Bereiche des Lichts der ersten spektralen Verteilung absorbieren.

6. Vorrichtung nach einem der vorhergehenden Ansprüche,
- bei der die Filterschicht (10) organische Farbstoffe umfasst.

7. Vorrichtung (1) nach einem der vorhergehenden Ansprüche,
- bei der die Filterschicht (10) eine Folienanordnung (11) umfassend eine adhäsive Schicht (11A), eine Kunststoffschicht (11B) auf der adhäsiven Schicht (11A) und eine Farbfilterschicht (11C) auf der Kunststoffschicht (11B), aufweist.

8. Vorrichtung nach dem vorhergehenden Anspruch,
- bei der die Kunststoffschicht (11B) ein Polymer umfasst, das ausgewählt ist aus: Polyester, Polycarbonat und Polyethylen.

9. Vorrichtung nach einem der Ansprüche 7 oder 8,
- bei der die Kunststoffschicht (11B) doppelbrechend ist.

10. Vorrichtung (1) nach einem der vorhergehenden Ansprüche,
- bei der eine Verkapselung (25) über dem funktionellen Bereich (5) vorhanden ist und der funktionelle Bereich (5) auf einem Substrat (20) angeordnet ist
- wobei die Filterschicht auf der, der dem funktionellen Bereich abgewandten Fläche des Substrats (20) und/oder der Verkapselung (25) angeordnet ist.

11. Vorrichtung nach einer der vorhergehenden Ansprüche 1 bis 6 und 10,
- bei der die Filterschicht (10) eine mittels eines TintenDruckverfahrens aufzubringende Licht-absorbierende Tinte umfasst.

12. Vorrichtung nach einem der vorhergehenden Ansprüche,
- bei der im Strahlengang (6) der Vorrichtung (1) zusätzlich ein Zirkularpolarisator (15) angeordnet ist.

13. Vorrichtung nach dem vorhergehenden Anspruch,
- bei der der Zirkularpolarisator (15) auf der Filterschicht (10) angeordnet ist, wobei eine Planarisierungsschicht (12) zwischen dem Zirkularpolarisator (15) und der Filterschicht (10) vorhanden ist.

14. Vorrichtung nach Anspruch 12,
- bei der die Filterschicht (10) eine doppelbrechende Kunststoffschicht (11B) umfasst und
- bei der die Filterschicht (10) dem Zirkularpolarisator (15) im Strahlengang (6) der Vorrichtung nachgeordnet ist.

15. Vorrichtung nach einem der Ansprüche 12 bis 14,
- bei der einer der Elektrodenschichten (5A, 5C) lichtreflektierend ist.

16. Vorrichtung nach einem der vorhergehenden Ansprüche,
- bei der zumindest Teilbereiche der Filterschicht (10) zu graphischen Elementen strukturiert sind.

17. Vorrichtung nach einem der vorhergehenden Ansprüche,
- bei der die Filterschicht unterschiedliche Teilbereiche umfasst,
- bei der der funktionelle Bereich eine Vielzahl von Bildpunkten umfasst,
- wobei ein Teilbereich der Filterschicht zumindest zwei Bildpunkten zugeordnet ist.

18. Verfahren zur Herstellung einer elektrolumineszierenden Vorrichtung (1) nach einer der vorhergehenden Ansprüche mit den Verfahrensschritten:
A) der funktionelle Bereich (5) wird bereitgestellt,
B) die Filterschicht (10) wird im Strahlengang (6) des funktionellen Bereichs (5) erzeugt.

19. Verfahren nach dem vorhergehenden Anspruch,
- bei dem im Verfahrensschritt B) die Filterschicht (10) mittels eines Druckverfahrens erzeugt wird.

20. Verfahren nach Anspruch 18,
- bei dem im Verfahrensschritt B) die Filterschicht (10) durch Aufbringen einer Folienanordnung (11) nach einem der Ansprüche 7 bis 9 erzeugt wird.

21. Verfahren nach dem vorhergehenden Anspruch,
- bei dem im Verfahrensschritt B) die Folienanordnung (11) mittels Laminierens aufgebracht wird.

22. Verfahren nach einem der Ansprüche 18 bis 21,
- wobei in einem Verfahrensschritt C) ein Zirkularpolarisator (15) im Strahlengang (6) der Vorrichtung erzeugt wird.

23. Verfahren nach dem vorhergehenden Anspruch,
- wobei eine Planarisierungsschicht (12) auf der Filterschicht (10) und dann auf der Planarisierungsschicht (12) der Zirkularpolarisator (15) erzeugt wird.

24. Verfahren nach Anspruch 22,
- bei dem der Zirkularpolarisator (15) zuerst erzeugt wird und dann auf dieser die Filterschicht erzeugt wird.

25. Verfahren nach einem der Ansprüche 19 bis 24,
- bei dem im Verfahrenschritt A) der funktionelle Bereich (5) auf einem Substrat (20) erzeugt wird und eine Verkapselung (25) über dem funktionellen Bereich (5) auf dem Substrat (20) angebracht wird
- wobei im Verfahrenschritt B) die Filterschicht auf der, dem funktionellen Bereich abgewandten Fläche des Substrats (20) und/oder der Verkapselung (25) erzeugt wird.

26. Verfahren nach dem vorhergehenden Anspruch,
- bei dem im Verfahrenschritt C) ein Zirkularpolarisator(15) auf der, dem funktionellen Bereich (5) abgewandten Fläche des Substrats (20) und/oder der Verkapselung (25) erzeugt wird.

27. Verwendung einer Vorrichtung nasch einem der Ansprüche 1 bis 17 zur Beleuchtung.

28. Verwendung einer Vorrichtung nasch einem der Ansprüche 1 bis 17 als Display zum Darstellen von graphischen Elementen und/oder Information.
